# EUROPÄISCHE PATENTANMELDUNG

(11) **EP 3 979 479 A1**
(43) Veröffentlichungstag der Anmeldung: **06.04.2022**
(21) Anmeldenummer: 20199337.5
(22) Anmeldetag: 30.09.2020
(51) Int. Cl.: H02M 1/32, G05B 23/02

(54) **EREIGNISÜBERWACHUNG BEI EINEM STROMRICHTER**

(71) Anmelder: Siemens Aktiengesellschaft, 80333 München (DE)
(72) Erfinder: Hecht, Fabian, 91207 Lauf (DE); Rosca, Cornel-Marian, 92364 Deining (DE)

(57) **Zusammenfassung**

Bei einem Verfahren zum Erzeugen einer Ereignisüberwachung bei einem Stromrichter, werden Protokolldaten nach einem Start des Stromrichters verwendet, wobei die Protokolldaten für eine Zeitperiode nach dem Start keinen Fehler zeigen, wobei die Zeitperiode bestimmbar ist. Meldungen werden Quellen für Fehler zugeordnet, wobei für eine Zuordnung eine Wahrscheinlichkeit errechnet wird.

## Beschreibung

Die Erfindung betrifft die Erkennung kritischer Ereignisse bei einem Stromrichter.

Durch einen Stromrichter ist es möglich einen drehzahlveränderbaren Betrieb einer elektrischen Maschine, wie zum Beispiel eines Motors, zu realisieren. Ein Stromrichter kann bei einer Anwendung der elektrischen Maschine als Generator auch zur Umwandlung des elektrischen Stromes dienen. Hierdurch kann beispielsweise eine Netzeinspeisung realisiert sein. Für die Anwendung bei einem Motor erfolgt beispielsweise eine Umwandlung der Netzleistung mit konstanter Frequenz und Spannung in eine Leistung mit variabler Frequenz und Spannung.

Der Stromrichter ist beispielsweise ein Umrichter, ein Gleichrichter bzw. ein Wechselrichter. Der Stromrichter kann wassergekühlt sein und/oder luftgekühlt sein. Der Stromrichter wird beispielsweise in Anwendungen mit hohen Anforderungen an Zuverlässigkeit und Qualität eingesetzt. Anwendungsbeispiele für Stromrichter sind beispielsweise:
- Industriepumpen und Lüfter
- Öl- und Gaspumpen und Kompressoren, z.B. elektrische Tauchpumpen und Hochgeschwindigkeitskompressoren
- Kesselgebläse (Saugzug und Druckbelüftung) zur Energieerzeugung
- Reinwasser- und Abwasserpumpen
- Anwendungen mit mehreren Motoren und Synchron-Transfer (z.B. Pipelines in der Öl- und Gasindustrie).

Diese Anwendungsbeispiele betreffen oftmals einen Einsatz des Stromrichters, bei dem insbesondere hohe Leistungen notwendig sind. Dies sind insbesondere Leistungen im einstelligen, zweistelligen oder dreistelligen Megawattbereich. Hierfür sind dann Stromrichter vorzugsweise eingesetzt, welche die Mittelspannung betreffen. Diese sind als Mittelspannungsstromrichter zu bezeichnen. Als Mittelspannung kann eine Spannung von größer, gleich 1000 V angesehen werden. Spannungen von 4000 V oder 6000 V können auch noch als Mittelspannung bezeichnet werden. Der Stromrichter ist beispielsweise ein variable-frequency drive (VFD). Der Sinamics Perfect Harmony GH180 ist ein Beispiel für einen VFD.

Wenn der Stromrichter Probleme hat, wird das Problem erkannt und in einer Logdatei dokumentiert bzw. gespeichert. Die Logdatei stellt ein Protokoll dar, wobei die erkannten und dokumentierten Probleme Protokolleinträge sind. Bei diesen Protokolleinträgen kann es sich um Warnungen handeln, um einen Anwender auf potenziell kritische Ereignisse hinzuweisen. Bei diesen Protokolleinträgen kann es sich auch um Fehler handeln, um einen Anwender auf einen Fehler hinzuweisen bzw. diesen Fehler zu dokumentieren. Kritische Ereignisse sind also beispielsweise auch Fehler. Für Ereignisse werden also Fehlermeldungen bzw. Warnmeldungen erzeugt. Fehler können zum Ausfall des Stromrichters führen bzw. geführt haben. Da ein Ausfall des Stromrichters jedoch in der Regel nicht nur zu einem Fehler, sondern zu einer Kaskade von Fehler- und Warnprotokollereignissen führt, wird die technische Ursache des Ausfalls des Stromrichters verschleiert und kann nur von Stromrichterexperten abgeleitet werden, die den Verlauf der Protokollereignisse analysieren.

Eine Aufgabe der Erfindung ist es eine Ereignisüberwachung des Stromrichters zu verbessern.

Eine Lösung der Aufgabe ergibt sich nach einem Verfahren nach Anspruch 1 bzw. nach einem Verfahren nach Anspruch 6 bzw. bei einer Ereignisüberwachung nach Anspruch 10. Ausgestaltungen ergeben sich beispielsweise gemäß der Ansprüche 2 bis 5, 7 bis 9 und 11.

Bei einem Verfahren zum Erzeugen einer Ereignisüberwachung bei einem Stromrichter, werden Protokolldaten nach einem Start des Stromrichters, insbesondere einem erfolgreichen Start, des Stromrichters, verwendet, wobei die Protokolldaten für eine Zeitperiode nach dem Start keinen Fehler zeigen, wobei die Zeitperiode bestimmbar ist. Der Stromrichter ist beispielsweise ein Mittelspannungsstromrichter. Die Protokolldaten betreffen beispielsweise Statusmeldungen, Warnmeldungen und/oder Fehlermeldungen. Derartige Meldungen betreffen beispielsweise folgende Elemente: eine Steuerung des Stromrichters, eine Regelung des Stromrichters, einen Temperatursensor, einen Luftmengensensor, einem Strommesser, einen Spannungsmesser, einen Leistungshalbleiter, etc. Ein erfolgreicher Start des Stromrichters ist insbesondere ein Start, bei welchem keine Fehlermeldungen und/oder Warnmeldungen generiert werden.

In einer Ausgestaltung des Verfahrens wird ein maschinelles Lernmodell, also eine künstliche Intelligenz, verwendet. Die künstliche Intelligenz ermittelt die wahrscheinlichsten technischen Grundursachen eines Ausfalls bzw. eines Fehlers auf automatisierte Weise. Mittels der künstlichen Intelligenz lässt sich eine Log-Ereignishistorie automatisiert analysieren. Die Log-Ereignishistorie entspricht den Protokolldaten.

In einer Ausgestaltung des Verfahrens wird ein Algorithmus für ein maschinelles Lernen verwendet, welcher die technische Grundursache, also die Quelle, eines als solchen erkannten Fehlers kategorisieren kann. Hierfür können unterschiedliche Schritte durchgeführt werden. In einem Schritt können Ausfälle eines historischen Stapels von Logbuchdaten, welche auch als Protokolldaten bezeichnet werden können, von einem Experten gekennzeichnet werden. In einem weiteren Schritt kann ein Algorithmus für maschinelles Lernen trainiert werden, um Fehlerereignisse in vordefinierte Ursachenkategorien zu kategorisieren. Es findet also eine Kategorisierung in Quellen für Fehler statt. Die künstliche Intelligenz kann so dahingehend trainiert werden, dass diese auf Grundlage einer Kaskade von Meldungen (eine oder eine Vielzahl von: Statusmeldungen, Warnmeldungen, Fehlermeldungen) auf eine Fehlerquelle schließt, d.h. diese angibt. In einer Ausgestaltung können auch mehrere Fehlerquellen angegeben sein, wobei jeweils eine Wahrscheinlichkeit für die Richtigkeit dieser Angabe errechnet bzw. ausgegeben wird.

In einer Ausgestaltung des Verfahrens werden also die Protokolldaten gekennzeichnet, wobei die Kennzeichnung eine zeitliche Abfolge protokollierter Meldungen betrifft. Die Protokolldaten weisen eben diese Meldungen auf. Die zeitliche Abfolge ergibt sich aus einer Kaskadierung von Meldungen. Derartige Meldungen können voneinander abhängig sein oder voneinander unabhängig sein. Eine Aufgabe der künstlichen Intelligenz ist es voneinander abhängigen Meldungen zu erkennen und einer ursächlichen Quelle zuzuordnen.

In einer Ausgestaltung des Verfahrens werden in einem Schritt historische Daten eines oder mehrerer Stromrichter, insbesondere des gleichen Typs, in einer Datenbank auf eine automatisierte Weise nach Fehlern durchsucht. Die Fehler werden zum Beispiel mit den folgenden Informationen über den Fehler aufgelistet, also voneinander unterschieden:
- Fehler, die beim Ausfall bis zu 1 Stunde nach dem ersten Fehler aufgetreten sind. Dieses Zeitintervall wurde für beste Ergebnisse konzipiert und ist eine typische Zeitspanne, in der Fehler Nebenwirkungen verursachen oder menschliches Eingreifen erfordern, um dieses Problem zu lösen; Diese Fehler betreffen z.B.: einen eingangsbezogenen Fehler (z.B. ein Problem in der Stromversorgung des Antriebs), einen kühlsystembezogenen Fehler (z.B. einen Ausfall der Luft- oder Wasserkühlung) und/oder einen Kommunikationsfehler der Leistungszelle (z.B. eine interne Antriebselektronik); Die gesammelten Informationen tragen zur Genauigkeit des vorgestellten Ansatzes bei;
- Warnungen, die vor dem ersten Fehler, insbesondere bis zu drei Stunden vor dem ersten Fehler, aufgetreten sind; dieses Zeitintervall stellt sicher, dass die kritischsten Informationen (Meldungen), die in einem kausalen Zusammenhang mit dem Fehler stehen, gesammelt werden und nach fachlicher Beratung und Engineering der Ergebnisse ausgewählt wurden; Es könnten jedoch für verschiedene Arten von Ausfällen unterschiedliche Zeitintervalle gewählt werden, da für sie eine unterschiedliche Zeit bis zum Ausfall erwartet wird; Bei kühlsystembedingten Fehlern könnte sogar eine Woche Zeit für die Ursachenanalyse wichtig sein (z.B. kann ein Leck in der Kühlflüssigkeit zu Alarmen führen, Tage oder Wochen bevor der tatsächliche Ausfall des Kühlsystems diagnostiziert werden kann);
- Die Zeit zwischen einem ersten und einem letzten Fehler; Diese Zeit ist wichtig, da sie Ausfälle einer Kombination von Fehlern, die fast gleichzeitig auftreten und daher wahrscheinlich in einem kausalen Zusammenhang stehen, von einer Reihe von Fehlern trennen kann, die durch menschliches Eingreifen verursacht wurden.

In einer Ausgestaltung des Verfahrens werden Meldungen Meldungen Quellen für Fehler zugeordnet. So kann erreicht werden, dass Folgefehler von einem ursächlichen Fehler unterschieden werden können.

In einer Ausgestaltung des Verfahrens werden zum Training der künstlichen Intelligenz Informationen über die zeitliche Abfolge von Meldungen und über eine kategorisierte Ursächlichkeit an einen Experten gegeben, der die Grundursache jedes Ausfalls ermittelt und beispielsweise in einer Liste als zumindest eine der folgenden Grundursachenkategorien vermerkt, die insbesondere alle kritischen Komponenten des Stromrichters abdecken:
- Power Cell (Leistungszelle / Leistungshalbleitermodul) bezogen (z.B. Ausfall aufgrund eines Power Cell-Problems),
- Power Cell kommunikationsbezogen (z.B. Ausfall aufgrund von Problemen bei der Kommunikation von Leistungszellen),
- Systembezogen,
- Kühlungsbedingt (z.B. Ausfall aufgrund eines Kühlsystemproblems),
- Eingabebedingt (z.B. Fehler aufgrund von Problemen bei der Eingabe eines Bedieners vor Ort zum Fahren des Stromrichters),
- Leistungsbezogen (z.B. Ausfall aufgrund von Problemen in der vom Antrieb angetriebenen Anwendung),
- Vorladung verbunden (z.B. Ausfall aufgrund von Vorladungsproblemen beim Start des Stromrichters),
- Antriebsverlust verbunden (z.B. Ausfall durch übermäßige Antriebsverluste),
- Manueller Halt (z.B. Kaskaden von Fehlern, die durch manuelles Abschalten des Antriebs ausgelöst werden).

In einer Ausgestaltung des Verfahrens wird für eine Zuordnung eine Wahrscheinlichkeit errechnet. So kann man gezielter an die Behebung eines Fehlers herangehen, ohne Mögliche aber unwahrscheinliche Ausfallmöglichkeiten zu vergessen.

In einer Ausgestaltung des Verfahrens wird in einem Schritt eine Liste der Fehler, also die Protokolldaten, mit Experten-Labels als Input für einen Algorithmus für maschinelles Lernen im Sinne eines überwachten Lernansatzes, verwendet. Der Algorithmus für maschinelles Lernen wird so optimiert, dass er in der Lage ist, vorher unbekannte Ausfälle in die Kategorien einzuordnen, wobei die Kategorien mit einer Kategorisierungswahrscheinlichkeit zurückgegeben werden, die z.B. die Grundursache, also die Quelle des Ausfalls ist: z.B. kühlungsbedingter Fehler (90%), systembezogener Fehler (10%).

In einer Ausgestaltung des Verfahrens wird also eine künstliche Intelligenz trainiert und so eine Ereignisüberwachung erzeugt.

Bei einem Verfahren zur Ereignisüberwachung bei einem Stromrichter, werden Meldungen erfasst, wobei die Meldungen einen Zeitstempel und eine Identifikation aufweisen, wobei durch die Abfolge der Meldungen ein Ereignis erkannt wird. Durch eine bestimmte Kaskadierung lässt sich auf eine bestimmte ursächliche Fehlerquelle schließen. Wobei ursächlich zusammenhängende Fehler zu erkennen sind.

So kann in einer Ausgestaltung mittels einer digitalen Plattform, insbesondere in einer Cloud, zur Optimierung von Antriebssystemen, Motoren, Umrichtern eine Datensammlung angelegt werden. Die Daten betreffen insbesondere Logfiles von entsprechenden Maschinen, wie einen Stromrichter oder einen Motor oder einen Transformator. Diese Daten können insbesondere dafür verwendet werden, um mit Hilfe eines Algorithmus für maschinelles Lernen die Grundursache eines ausgewählten Fehlers zu kategorisieren. So können Logbuchdaten, die von einem Stromrichter erhalten werden, folgende Informationen aufweisen:
- den Zeitstempel des Log-Ereignisses,
- die Schwere des Protokollereignisses: Info, Fehler oder Warnung,
- einen Text des Log-Ereignisses,
- den Auslöser des Log-Ereignisses.

So wird z.B. ein Ausfall eines Antriebs durch das Auftreten eines oder mehrerer Fehler nach einer bestimmten fehlerfreien Zeit nach einem erfolgreichen Neustart angezeigt. Dabei wird die fehlerfreie Zeit als mindestens sieben Tage definiert. Dies ist eine charakteristische Zeit, die z.B. während der Entwicklung festgelegt wurde, um sicherzustellen, dass sich der Antrieb in einem regulären Betriebsmodus befand. Dabei weist der Antrieb zumindest einen Stromrichter auf.

In einer Ausgestaltung des Verfahrens weist die Identifikation einen Meldetyp, einen Text und/oder eine Quelle der Meldung auf. So kann eine Eineindeutigkeit sichergestellt werden.

In einer Ausgestaltung des Verfahrens ist das Ereignis ein Ausgangsfehler, wobei zur Erkennung des Ereignisses eine künstliche Intelligenz eingesetzt wird, wobei die künstliche Intelligenz eine Cloud-Anwendung ist. So kann ortsunabhängig immer die gleiche Qualität an künstlicher Intelligenz genutzt werden.

In einer Ausgestaltung des Verfahrens wird eine Ereignisüberwachung der beschriebenen Art verwendet. Die Ereignisüberwachung eines Stromrichters kann also eine künstliche Intelligenz aufweisen und/oder auf diese zugreifen.

Eine Ereignisüberwachung eines Stromrichters weist eine Kommunikationseinrichtung und eine Datenverarbeitung zur Durchführung eines der beschriebenen Verfahren auf.

Nunmehr ist es möglich, ohne tiefgreifende technische Kenntnisse die Ursache des Versagens eines Stromrichters aus den Log-Ereignissen zu extrahieren. Nur für Experten war es bislang möglich, die Logfiles des Stromrichters zu analysieren und die Ursache eines Ausfalls abzuleiten. Infolgedessen ist nunmehr z.B. folgendes möglich:
- ein Anwender kann den Ausfall seines Stromrichters schnell analysieren und seine Anwendung schneller wieder zum Laufen bringen;
- der Anwender kann die Ausfälle seines Antriebs, welcher zumindest einen Stromrichter aufweist, in der Vergangenheit überprüfen, um seine Anlage für weniger Ausfallzeiten zu optimieren;
- Stromrichter können leichter überprüft werden und Servicemaßnahmen können leichter vorgeschlagen werden;
- ein schnellerer Neustart eines Stromrichters ist möglich, da die Zeit für die Ursachenanalyse durch Experten drastisch verkürzt ist.

Im Gegensatz zur manuellen Analyse ist die hier vorgestellte automatisierte Lösung insbesondere in der Lage, eine beliebige Anzahl von Fehlern gleichzeitig zu verarbeiten.

Ermöglicht ist auch ein Cloud-Analyse-Ansatz, da die Logfile-Daten vom Stromrichter in der Cloud gespeichert werden. Infolgedessen wird z.B. die Ursachenanalyse auf skalierbaren Cloud-Instanzen in einer geeigneten Python-Umgebung bereitgestellt. Diese technischen Merkmale tragen zum großen Vorteil des vorgestellten Ansatzes bei, da sie eine Prozessautomatisierung ermöglichen.

In einer Ausgestaltung der Erfindung wird für den Algorithmus der künstlichen Intelligenz als ein Schlüsselalgorithmus der aus Expertenwissen abgeleitete maschinelle Lernansatz (Labelling) verwendet, der als automatisiertes Modul zur Ursachenanalyse implementiert ist. Insbesondere beruht die Fehlerextraktion auf historischen Daten wie auch die Expertenetikettierung.

Die Merkmale der einzelnen beanspruchten bzw. beschriebenen Gegenstände sind ohne Weiteres miteinander kombinierbar. Im Folgenden wird die Erfindung beispielhaft anhand von Figuren näher dargestellt und erläutert. Die in den Figuren gezeigten Merkmale können fachmännisch zu neuen Ausführungsformen kommbiniert werden, ohne die Erfindung zu verlassen. Es zeigen
- FIG 1: ein erstes Beispiel und,
- FIG 2: ein zweites Beispiel.

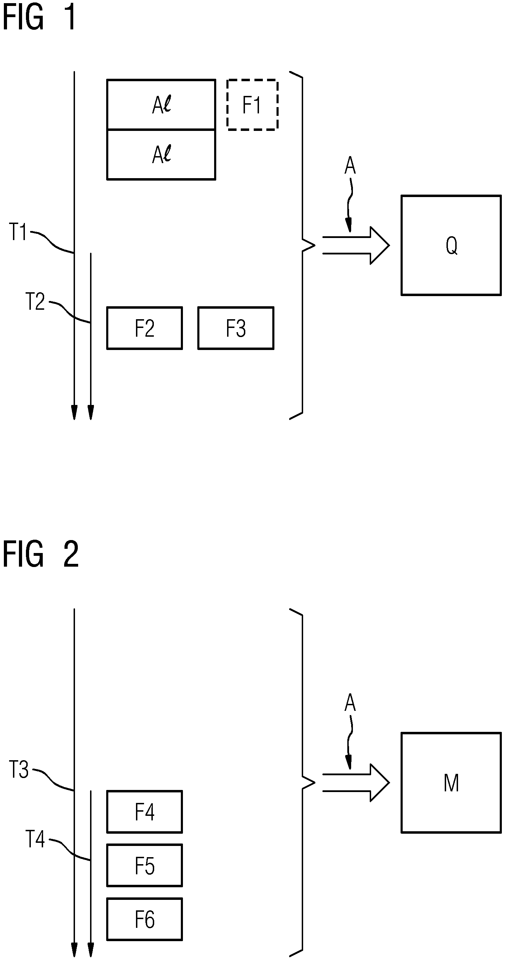

Die Darstellung nach FIG 1 zeigt zwei Fehler F1 und F2 traten gleichzeitig auf (F1: Cooling Sys Mv Trip und F2: Cooling Sys Vfd Trip). Diese Fehler werden erfasst, sobald sie innerhalb von einer Stunde T2 auftreten und als Fehler erkannt werden. Bis zu drei Stunden T3 vor dem ersten Fehler wurde der Alarm Al Coolnt Tank Level < 30 zweimal ausgelöst. Der Algorithmus A kommt zu dem Schluss, dass es sich hierbei um einen Ausfall Q des Kühlsystems handelt. Im Zeitraum T3 hätte z.B. auch ein erster Fehler F1 auftreten können, der nichts mit dem Ausfall Q zu tun hat.

Die Darstellung nach FIG 2 zeigt, dass innerhalb von zwei Sekunden T4 drei verschiedene Fehler F4, F5 und F6 auftraten: F4 Eingangsschutzfehler, F5 Emergencia Stop Remoto und F6 Notstopp. Drei Stunden T3 vor dem ersten Fehler F4 werden keine Alarme gefunden. Wenn man nur den "Eingangsschutzfehler" betrachtet, kann ein Experte zu dem Schluss kommen, dass der Antrieb durch ein schwerwiegendes antriebsbezogenes Problem gestoppt wurde. "Emergencia Stop Remoto" und "Notstopp" führen jedoch zu der Schlussfolgerung des Algorithmus, dass es sich um einen manuellen Stopp des Antriebs handelt. Dies ist hilfreich, da es die Suche nach einem Problem im Ereignisprotokoll verhindert und es dem Benutzer direkt ermöglicht, den Stromrichter neu zu starten.

Zum Beispiel kann infolgedessen der Algorithmus für maschinelles Lernen, wenn er die Fehler und die Warnung kennt, die bei einem Ausfall aufgetreten sind, die Ursache eines bisher nicht gesehenen Ausfalls mit einer Genauigkeit von >95 % bestimmen. Der verwendete Algorithmus des maschinellen Lernens basiert z.B. auf einer C-Support-Vektor-Klassifikation. Die Ursachenanalyse kann selektiv für einen einzelnen Ausfall des Stromrichters (spezifiziert als kritisches Protokollereignis) ausgelöst werden, so dass sie dem Service und dem Bediener bei Bedarf zugänglich ist.

## Patentansprüche

1. Verfahren zum Erzeugen einer Ereignisüberwachung bei einem Stromrichter, wobei Protokolldaten nach einem Start des Stromrichters verwendet werden, wobei die Protokolldaten für eine Zeitperiode nach dem Start keinen Fehler zeigen, wobei die Zeitperiode bestimmbar ist.

2. Verfahren nach Anspruch 1, wobei die Protokolldaten gekennzeichnet werden, wobei die Kennzeichnung eine zeitliche Abfolge protokollierter Meldungen betrifft.

3. Verfahren nach Anspruch 1 oder 2, wobei Meldungen Quellen für Fehler zugeordnet werden und/oder sind.

4. Verfahren nach Anspruch 3, wobei für eine Zuordnung eine Wahrscheinlichkeit errechnet wird.

5. Verfahren nach einem der Ansprüche 1 bis 4, wobei eine künstliche Intelligenz trainiert wird und derart insbesondere eine Ereignisüberwachung erzeugt ist.

6. Verfahren zur Ereignisüberwachung bei einem Stromrichter, wobei Meldungen erfasst werden, wobei die Meldungen einen Zeitstempel und eine Identifikation aufweisen, wobei durch die Abfolge der Meldungen ein Ereignis erkannt wird.

7. Verfahren nach Anspruch 6, wobei die Identifikation einen Meldetyp, einen Text und/oder eine Quelle der Meldung aufweist.

8. Verfahren nach Anspruch 6 oder 7, wobei das Ereignis ein Ausgangsfehler ist, wobei zur Erkennung des Ereignisses eine künstliche Intelligenz eingesetzt wird, wobei die künstliche Intelligenz eine Cloud-Anwendung ist.

9. Verfahren nach einem der Ansprüche 6 bis 8, wobei eine nach Anspruch 1 bis 4 erzeugte Ereignisüberwachung verwendet wird.

10. Ereignisüberwachung eines Stromrichters, welche eine künstliche Intelligenz aufweist.

11. Ereignisüberwachung nach Anspruch 10, wobei ein Verfahren nach einem der Ansprüche 1 bis 9 verwandt ist.
